Europäisches Patentamt

European Patent Office

Office européen des brevets

(11) Veröffentlichungsnummer: **0 308 678**

**A1**

## (12) EUROPÄISCHE PATENTANMELDUNG

(21) Anmeldenummer: 88113890.3

(22) Anmeldetag: 25.08.88

(51) Int. Cl.⁴: **G01R 25/04**

(30) Priorität: 25.09.87 DE 3732447

(43) Veröffentlichungstag der Anmeldung:
29.03.89 Patentblatt 89/13

(84) Benannte Vertragsstaaten:
**DE FR GB IT NL**

(71) Anmelder: **Siemens Aktiengesellschaft Berlin
und München
Wittelsbacherplatz 2
D-8000 München 2(DE)**

(72) Erfinder: **Brust, Hans-Detlef
Martin-Luther-Strasse 2
D-6602 Dudweiler(DE)**

(54) **Verfahren und Vorrichtung zur Phasenmessung von Signalen an einem Messpunkt mit Hilfe eines unmodulierten Korpuskularstrahls.**

(57) Verfahren und Vorrichtung zur Phasenmessung von beliebigen Signalen an einem Meßpunkt, beispielsweise von Oberflächenwellen auf piezoelektrischen Substraten, bei dem man auf der Oberfläche einer piezoelektrischen Eigenschaft aufweisenden Probe Oberflächenwellen anregt. Ein Meßpunkt auf der Probenoberfläche wird mit Hilfe eines Korpuskularstrahls (PE) abgetastet und an dem jeweils beaufschlagten Meßpunkt der Probenoberfläche wird ein sekundäres elektrisches Signal (SE) über einen Detektor (DT) einer Auswerteschaltung (AS) zugeführt. Mit Hilfe einer Rückkopplung (RK) wird innerhalb der Auswerteschaltung (AS) der Phasendetektor (PD) in einem linearen Bereich seiner Ausgangskennlinie betrieben. Hierdurch ist es möglich, die Phase am Phasendetektor konstant zu halten. Durch die Rückkopplung (RK) wird die Phase des zu untersuchendes Signals, beispielsweise der Oberflächenwelle, die an dem Interdigitalwandler (IDW) erzeugt wird, beeinflußt.

FIG 1

## Verfahren und Vorrichtung zur Phasenmessung von Signalen an einem Meßpunkt mit Hilfe eines unmodulierten Korpuskularstrahls

Die Erfindung betrifft ein Verfahren zur Phasenmessung von Signalen an einem Meßpunkt nach dem Oberbegriff des Patentanspruchs 1 und eine Vorrichtung zur Durchführung des Verfahrens.

Elektronische Bauelemente, in denen Oberflächenwellen durch Wandlerstrukturen auf Kristalloberflächen angeregt und detektiert werden, gewinnen in der Nachrichten- und Hochfrequenztechnik zunehmend an Bedeutung. Ihre Herstellung in Planartechnologie kann sehr genau, gut reproduzierbar und verhältnismäßig preiswert erfolgen und ihr Entwurf ist mit den Methoden des Computer-Aided-Design (CAD) immer besser optimierbar. Dennoch ergeben sich für solche Bauelemente häufig nicht tolerierbare Abweichungen zwischen realisierter und geforderter Übertragungsfunktion. Da man die Ursachen dieser Abweichungen durch Messung der Übertragungsfunktion allein nicht erkennen bzw. lokalisieren kann, müssen auch die ein Wellenfeld an der Oberfläche des Bauelementes charakterisierenden Parameter, beispielsweise mit Laser- und Elektronensonden ortsaufgelöst gemessen werden. Elektronenstrahlmeßverfahren zur stroboskopischen Abbildung der Wellenfronten laufender Oberflächenwellen in modifizierten Rasterelektronenmikroskopen sind beispielsweise aus den Artikeln von H.P. Feuerbaum et al "Visualization of Traveling Surface Acoustic Waves Using a Scanning Electron Microscope" (SEM. 1980, I. S. 502-509) bzw. "Scanned Electron Beam Probe Shows Surface Acoustic Waves in Action" (Electronics, 19. Mai 1983. S. 132-136) bekannt.

Zur Verbesserung des Entwurfs von Oberflächenwellen-Bauelementen müssen immer mehr physikalische Effekte (Kantenreflexion, Beugungseffekte) in den CAD-Modellen berücksichtigt werden. Um festzustellen, welche Effekte das Übertragungsverhalten des Oberflächenwellen-Bauelements am stärksten beeinflussen bzw. zur Bestimmung der Modellparamter reicht die Abbildung des Wellenfeldes allein nicht mehr aus, so daß zusätzliche Messungen der Ausbreitungsgeschwindigkeit, der Amplitude und der Phase von Oberflächenwellen notwendig sind.

Ein weiterer wichtiger Anwendungsfall für die Messung der Phase, beispielsweise mechanischer Wellen, ist die zerstörungsfreie Werkstoffprüfung. Beim sog. SLAM (Scanning Laser Acoustic Microscope) wird in das zu untersuchende Werkstück eine mechanische Volumenwelle eingekoppelt, deren Ausbreitung im Werkstück durch eventuell vorhandene Störungen, wie Risse und Einschlüsse, beeinflußt wird. Trifft die Welle auf die Werkstückoberfläche, so verursacht sie dort einerseits eine Auslenkung der Oberfläche und kann zum anderen durch Modenkopplung auch Oberflächenwellen erzeugen. Ein Bild der Wellenverteilung auf der Oberfläche, insbesondere der Phase der Welle, läßt Rückschlüsse darauf zu, ob Störungen in dem Werkstück vorhanden sind, und falls dies der Fall ist, welcher Art diese Störungen sind. Auf diese Art und Weise ist eine zerstörungsfreie Prüfung des Werkstücks möglich.

Zur Bestimmung der Phase wurden bisher meist stroboskopische Abbildungen ausgewertet, eine Methode, die nur eine sehr geringe Genauigkeit besitzt. Neben dieser eher qualitativen Methode kann die Phase auch mit Hilfe eines Lock-In-Verstärkers als Phasendetektor gemessen werden. Herkömmliche Phasendetektoren weisen jedoch, und dazu zählt auch ein Lock-In-Verstärker, nur in einem eng begrenzten Phasenbereich eine hinreichend große Empfindlichkeit und Genauigkeit auf. Insbesondere gilt dies für alle Phasendetektoren mit $\cos\varphi$-Charakteristik. Außerdem können vorgeschaltete Filter Phasenverzerrungen und damit eine Verfälschung der Messung bewirken.

Der Erfindung liegt die Aufgabe zugrunde, ein Verfahren und eine Vorrichtung der eingangs genannten Art anzugeben, mit dem die Phase von Signalen an einem Meßpunkt schnell und sehr genau gemessen werden kann.

Diese Aufgabe wird erfindungsgemäß durch ein Verfahren nach Anspruch 1 und eine Vorrichtung nach Anspruch 12 gelöst.

Der mit der Erfindung erzielbare Vorteil besteht insbesondere darin, daß sich hiermit eine genaue Messung der Phase von Signalen an einem Meßpunkt innerhalb eines weiten Frequenzbereichs mit sehr hoher Empfindlichkeit und Genauigkeit durchführen läßt.

Die Ansprüche 2 bis 11 sind auf eine bevorzugte Ausgestaltung des erfindungsgemäßen Verfahren gerichtet, während die Ansprüche 13 bis 27 Vorrichtungen zur Durchführungen des Verfahrens betreffen.

Die Erfindung wird nachfolgend anhand der Phasenmessung von Oberflächenwellen mit Hilfe von Zeichnungen näher erläutert. Dabei zeigen:

Fig. 1 und 2 je eine Vorrichtung zur Durchführung des erfindungsgemäßen Verfahrens,

Fig. 3 die Ausgangskennlinie eines Phasendetektors in Abhängigkeit von der Phase eines Eingangssignals.

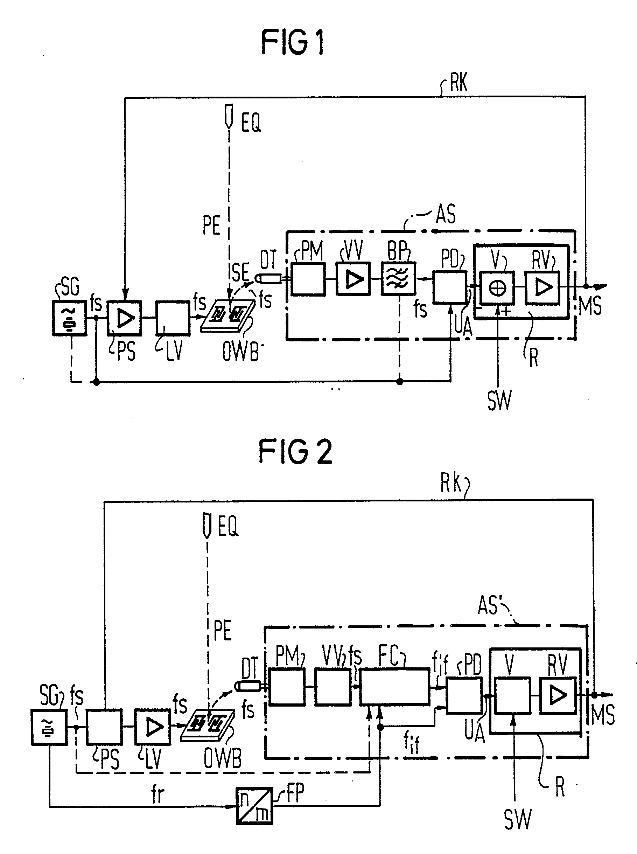

Figur 1 zeigt eine erste Vorrichtung zur Durchführung des erfindungsgemäßen Verfahrens. Zur Messung der Phase von Oberflächenwellen an einem Meßpunkt auf der Oberfläche eines Oberflächenwellen-Bauelementes OWB wird einer der auf dem OFW-Bauelement vorhandenen sog. Interdigitalwandler IDW zur Abstrahlung von akustischen OFW eingesetzt. Dies geschieht mit Hilfe eines Signalgenerators SG, der den Interdigitalwandler IDW über einen Leistungsverstärker LV mit einer sinusförmigen Spannung der Frequenz fs mit einer Phase ρ anregt. Die an den Metallelektroden des Wandlers IDW anliegende Wechselspannung führt über den piezoelektrischen Effekt zur periodischen Deformation der Kristalloberfläche, die sich dann als akustische Wellen mit Geschwindigkeiten zwischen etwa 3000 m/s und 4000 m/s auf dem Oberflächenbauelement OWB ausbreiten.

Die Welle dringt bis zu einer Tiefe von etwa einer Wellenlänge in den Kristall ein, wobei die Deformation der Oberfläche gewöhnlich im Bereich zwischen 0,1 und 10 Angström liegt. Dabei führt die elektromechanische Kopplung wieder über den piezoelektrischen Effekt zu lokalen Oberflächenpotentialen, die in einem Empfangswandler detektiert oder mit einem Elektronenstrahl PE mit Hilfe des Potentialkontrasteffekts abgetastet werden können. Dieser feingebündelte kontinuierliche Primärelektronenstrahl PE wird vorzugsweise in der elektronenoptischen Säule eines modifizierten Rasterelektronenmikroskops erzeugt, die im wesentlichen eine aus Kathode, Wehnelt-Elektrode und Anode bestehende Elektronenkanone EQ und eine Reihe weiterer, in Figur 1 aus Gründen der Übersichtlichkeit nicht dargestellter magnetischer Linsen zur Strahlformung und Fokussierung des Primärelektronenstrahls PE aufweist.

Die am jeweiligen Meßpunkt von den Primärelektronen im piezoelektrischen Kristall erzeugten Sekundärelektronen treten durch dessen Oberfläche aus und werden über eine Absaugspannung in Richtung des beispielsweise aus Kollektor, Szintillator und Lichtleiter bestehenden Detektors DT beschleunigt. Der im Detektor DT nachweisbare und aufgrund des Potentialkontrasts in seiner Höhe in Abhängigkeit von dem am Meßpunkt anliegenden Potential schwankende Sekundärelektronenstrom wird anschließend einer Auswerteschaltung AS zugeführt. In der Auswerteschaltung AS wird in einem Photomultiplier PM der Sekundärelektronenstrom in ein elektrisches Signal (Potentialkontrastsignal) umgewandelt und in einem nachgeschalteten Vorverstärker VV verstärkt. Zur Verbesserung des Signal/Rauschverhältnisses kann das Sekundärelektronensignal mit der Signalfrequenz mit Hilfe eines einstellbaren und auf die Signalfrequenz abgestimmten Bandpaßfilter BP, das hinter dem Vorverstärker VV angeschlossen ist, ausgefiltert werden. Das Bandpaßfilter ist zur Steuerung seiner Mittenfrequenz entweder mit dem Signalgenerator SG oder mit einer zusätzlichen Steuereinheit, beispielsweise einem Rechner, verbunden.

Die Phase ρ des gegebenenfalls ausgefilterten Sekundärelektronensignals wird im Phasendetektor PD, der hinter dem Bandpaß BP angeordnet ist, detektiert. Hierzu benötigt der Phasendetektor PD ein Referenzsignal mit der Referenzfrequenz, die der Signalfrequenz fs entspricht, das in diesem Falle aus dem Signalgenerator SG gewonnen wird.

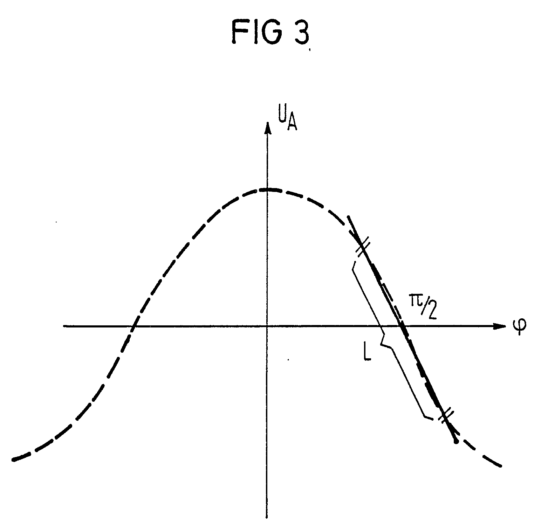

Als Phasendetektor kommt insbesondere ein Lock-In-Verstärker oder ein phasenempfindlicher Gleichrichter in Betracht. In diesem Fall kann meist auf ein Bandpaßfilter BP verzichtet werden. Um die Phasenmessung mit hoher Empfindlichkeit und Genauigkeit durchführen zu können, wird nun die Phase ρ am Phasendetektor PD konstant gehalten. Dazu muß man die Phase der Ansteuersignale am Interdigitalwandler IDW entsprechend verändern. Dies geschieht mit Hilfe einer Rückkopplung RK. Das Rückkopplungssignal gewinnt man durch einen Vergleich des Ausgangssignals $U_A$ des Phasendetektors mit einem Sollwert SW in einem Regler R, der hinter den Phasendetektor PD geschaltet ist. In der in Fig. 1 angegebenen Realsisierung besteht der Regler R aus einem Vergleicher V zum Vergleich des Ausgangssignals $U_A$ des Phasendetektors mit dem Sollwert SW und somit zur Bestimmung der Regeldifferenz und aus einem Regelverstärker RV. Der Sollwert SW sollte dabei so eingestellt werden, daß sich der Arbeitspunkt auf der Kennlinie des Phasendetektors im steilsten Bereich dieser Kennlinie befindet (siehe hierzu auch Figur 3), da man dann die höchste Empfindlichkeit und Genauigkeit erreicht. Die Regeldifferenz wird sodann einem Regelverstärker RV (z. B. mit P- oder PI-Verhalten) zugeführt und verändert danach beispielsweise die Phase ρ des Ansteuersignals über einen steuerbaren Phasenschieber PS, wobei dieser zwischen Signalgenerator SG und Leistungsverstärker LV geschaltet ist. Anstelle einer solchen Phasenschiebung mit Hilfe eines Phasenschiebers als eigenständigem Bauelement kann auch eine Frequenz- oder Phasenmodulation des Signalgenerators SG vorgenommen werden, da nur die Phasendifferenz entscheidend ist. Ebenso ist es möglich, für die definierte Zeitspanne die Signalfrequenz von dem Signalgenerator SG zu verändern und danach wieder auf den Sollwert zurückzukehren und so eine Phasenschiebung zu erreichen. Dies ist besonders bei computer gesteuerten Geräten leicht möglich. Bei einigen kommerziell erhältlichen Generatoren, wie etwa den Modellen hp 8656 und hp 8642 der Firma Hewlett-Packard, ist eine solche Vorrichtung zur Phasenschiebung bereits serienmäßig eingebaut. Die Stellgröße selbst kann als Meßsignal MS herangezogen werden. Das Meßsignal kann allerdings auch - etwas komplizierter - durch Messung der Phase des den Interdigitalwandler anregenden Ansteuersignals gewonnen werden. Eine derartige Phasenschiebung bzw. Modulation läßt sich über einen weiten Frequenzbereich mit sehr hoher Genauigkeit durchführen. Dies ist ein wesentlicher Vorteil gegenüber den Verfahren zur Phasenmessung nach dem Stand der Technik.

Ebenfalls ist es möglich, die Phase der dem Phasendetektor PD zugeführten Referenzfrequenz, die der Signalfrequenz $f_s$ entspricht, mit Hilfe eines Phasenschiebers PS zu verändern. Zur Durchführung der Phasenschiebung ist im übrigen nicht unbedingt ein eigenständiger Phasenschieber erforderlich. Eine Phasenschiebung kann auch durch eine Frequenz- oder Phasenmodulation bewirkt werden.

Figur 2 zeigt eine zweite technische Realisierung zur Durchführung des erfindungsgemäßen Verfahrens. Die Schaltung entspricht in wesentlichen Punkten der Schaltung aus Figur 1 und entsprechende Bezugszeichen aus Figur 1 finden hier Verwendung. Nachteilig bei einer Anordnung nach Figur 1 ist, daß die Phasendetektion bei der Signalfrequenz $f_s$, die sich in einem sehr weiten Frequenzbereich ändern kann, erfolgen muß. Daher kann es vorteilhaft sein, vor der Phasendetektion eine Konversion der Signalfrequenz $f_s$ auf eine feste Zwischenfrequenz $f_{if}$, wie in der Anordnung nach Figur 2 dargestellt, durchzuführen. Dazu beinhaltet die Auswerteschaltung AS' eine Einrichtung Zur Frequenzumsetzung FC, die zwischen dem Vorverstärker VV und dem Phasendetektor PD verschaltet ist. Die Einrichtung zur Frequenzumsetzung FC enthält gegebenenfalls einen Bandpaß zum Ausfiltern des Sekundärelektronensignals mit der Signalfrequenz $f_s$, einen nachgeschalteten Mischer mit spannungsgesteuertem Frequenzoszillator. Der Bandpaß ist analog wie in der Anordnung nach Figur 1 zur Veränderung seiner Mittenfrequenz mit dem Signalgenerator SG verbunden. Bei der Frequenzumsetzung muß die Phase des Sekundärelektronensignals bis auf eine konstante Phasenverschiebung erhalten bleiben. Daher ist eine Synchronisation mit dem Signalgenerator SG erforderlich. Vorzugsweise sollte die Zwischenfrequenz $f_{if}$ so gewählt werden, daß sie sich durch einfache Teilung oder Vervielfachung aus einer Referenzfrequenz $f_r$ der Ansteuersignale aus dem Signalgenerator gewinnen läßt. Der Mischer in der Einrichtung zur Frequenzumwandlung FC ist daher über einen Frequenzteiler oder Frequenzvervielfacher FP mit dem Signalgenerator verbunden. Dem Phasendetektor PD wird über den Frequenzteiler oder Frequenzvervielfacher FP ebenfalls ein Signal mit der Zwischenfrequenz $f_{if}$ als Referenzsignal zugeführt. Der Frequenzteiler oder Frequenzvervielfacher FC kann entfallen, wenn als feste Zwischenfrequenz $f_{if}$ die Referenzfrequenz $f_r$ selbst des Si-gnalgenerators SG gewählt wird.

Figur 3 zeigt die Ausgangskennlinie eines Phasendetektors, in der die Funktion der Ausgangsspannung $U_A$ in Abhängigkeit der Phase $\rho$ dargestellt ist. Wie bereits in Figur 1 angedeutet, besitzen die meisten Phasendetektoren eine $\cos\rho$ - Charakteristik, die sich jedoch in einem Bereich L um den Punkt $\rho = \pi\,2$ linearisieren läßt. Innerhalb dieses annähernd linearen Bereiches L ist die Ausgangsspannung proportional zur Phasendifferenz. Zugleich ist dieser Bereich der steilste der Kennlinie. Dort rufen bereits kleine Änderungen der Phasendifferenz größere Änderungen der Ausgangsspannung $U_A$ des Phasendetektors PD hervor. Daher ist in diesem Bereich eine Messung der Phasendifferenz mit sehr hoher Empfindlichkeit und dadurch auch mit großer Genauigkeit möglich.

Aufgabe der Rückkopplung RK in der Vorrichtung nach Figur 1 und Figur 2 ist es, den Arbeitspunkt des Phasendetektors PD innerhalb des linearen und sehr steilen Bereichs L konstant zu halten. Außerhalb dieses Bereichs L ist eine Messung der Phase nur noch mit geringer Empfindlichkeit und damit mit recht großen Fehlern möglich.

Die Anregung der Oberflächenwellen muß nicht unbedingt mit einem Interdigitalwandler IDW erfolgen, ebenso ist z.B. auch eine Anregung auf photoakustischem oder elektroakustischem Wege denkbar. In dem Fall der elektroakustischen Anregung werden mit einem Primärstrahl die Wellen erzeugt. Die Wellen können dann entweder mit einem zweiten Primärstrahl oder einem Interdigitalwandler IDW detektiert werden. Beim Empfang der Wellen mit einem Interdigitalwandler entfällt ein eigenständiger Detektor (siehe hierzu K. Jamonouchi et al: Exciting of surface acoustic waves using electron acoustic microscope", Jap. Journ. Appl. Phys. 23, 1984, S. 191-193 und H.P. Feuerbaum et al "Examination of surface acoustic wave components using a scanning electron microscope", SEM 1983 I. S. 55-63). Das hier beschriebene Verfahren läßt sich sinngemäß auch auf alle anderen Phasenmessungen mit der Elektronen- oder Lasersonde übertragen.

Phasenmessungen an Oberflächenwellen mit der Lasersonde hierzu sind beispielsweise in den Veröffentlichungen von H. Engan: IEEE "Transactions on sonics and ultrasonics -29", 1982, auf Seite 281 und IEEE "Transactions on sonics and ultrasonics -25", 1978 auf S. 372 beschrieben. In den Anmeldungen P 37 25 313.1 ( = VPA 87 P 8064 DE) und P 37 25 355.7 ( = VPA 87 P 8063 DE) wird eine Spannungsmessung mit einer Elektronensonde durch Messungen im Frequenzbereich vorgeschlagen wurden. Zur Durchführung der dabei erforderlichen Phasenmessung kann ebenfalls das hier beschriebene Verfahren eingesetzt werden.

## Ansprüche

1. Verfahren zur Phasenmessung von Signalen an einem Meßpunkt auf einer Probe (OWB), bei dem mindestens ein Punkt der Probenoberfläche mit Hilfe eines Korpuskularstrahls (PE) abgetastet wird und bei dem jeweils abgetasteten Meßpunkt der Probenoberfläche ein sekundäres elektrisches Signal (SE), insbesondere über einen Detektor (DT) abgeleitet und einer Auswerteeinheit (AS) mit einem Phasendetektor (PD) zugeführt wird und bei dem die Probe über Ansteuerungssignale versorgt wird, **dadurch gekennzeichnet**, daß die Phase des sekundären elektrischen Signals (SE) am Phasendetektor (PD) konstant gehalten wird.

2. Verfahren nach Anspruch 1, **dadurch gekennzeichnet**, daß die Probe über Ansteuerungssignale mit der Signalfrequenz ($f_s$) versorgt wird.

3. Verfahren zur Phasenmessung nach Anspruch 1 oder 2, **dadurch gekennzeichnet**, daß das sekundäre elektrische Signal (SE) über ein in der Auswerteschaltung enthaltenes durchstimmbares Filter (BP) ausgefiltert wird, daß dem durchstimmbaren Filter (BP) ein Steuersignal zugeführt wird, das die Mittenfrequenz des durchstimmbaren Filters bestimmt.

4. Verfahren zur Phasenmessung nach Anspruch 3, **dadurch gekennzeichnet**, daß das Steuersignal ein Referenzsignal mit der Referenzfrequenz, die der Signalfrequenz ($f_s$) entspricht, ist und daß das Steuersignal aus den Ansteuerungssignalen für die Probe gewonnen wird.

5. Verfahren zur Phasenmessung nach Anspruch 4, **dadurch gekennzeichnet**, daß das mit der Signalfrequenz ($f_s$) sekundäre elektrische Signal (SE) mit dem Steuersignal, welches die Referenzfrequenz hat, gemischt wird, daß bei der Mischung die Phase des sekundären elektrischen Signals (SE) erhalten bleibt.

6. Verfahren zur Phasenmessung nach einem der Ansprüche 1 bis 5, **dadurch gekennzeichnet**, daß die Signale an einem Meßpunkt Oberflächenwellen sind.

7. Verfahren zur Phasenmessung nach Anspruch 6, **dadurch gekennzeichnet**, daß die Signale Oberflächenwellen auf piezoelektrischen Substraten sind, bei denen man auf der Oberfläche einer piezoelektrische Eigenschaften aufweisenden Probe Oberflächenwellen anregt und bei denen man daß die Oberfläche begleitende lokale elektrische Feld an mindestens einem Punkt der Probenoberfläche mit Hilfe des Korpuskularstrahls (PE) abtastet.

8. Verfahren zur Phasenmessung nach einem der Ansprüche 1 bis 7, **dadurch gekennzeichnet**, daß die Phasendifferenz zwischen dem sekundären elektrischen Signal (SE) und einem Referenzsignal im steilsten Abschnitt (L) einer Ausgangskennlinie des Phasendetektors (PD) konstant gehalten wird.

9. Verfahren zur Phasenmessung nach einem der Ansprüche 1 bis 8, **dadurch gekennzeichnet**, daß die Phase des sekundären elektrischen Signals (SE) über eine Rückkopplung (RK) geregelt wird, daß ein Rückkopplungssignal mit einem Vergleich eines Ausgangssignals ($U_A$) des Phasendetektors mit einem vorgegebenen Sollwert (SW) gewonnen wird, daß das Rückkopplungssignal die Phase der Ansteuerungssignale für die Probe so beeinflußt, daß die Phasendifferenz der Eingangssignale am Phasendetektor (PD) konstant bleibt.

10. Verfahren zur Phasenmessung nach einem der Ansprüche 1 bis 8, **dadurch gekennzeichnet**, daß die Phase des sekundären elektrischen Signals (SE) über eine Rückkopplung geregelt wird, daß ein Rückkopplungssignal aus einem Vergleich eines Ausgangssignals ($U_A$) des Phasendetektors mit einem vorgegebenen Sollwert (SW) gewonnen wird, daß das Rückkopplungssignal die Phase eines Referenzsignals mit einer Referenzfrequenz für den Phasendetektor (PD) so beeinflußt, daß die Phasendifferenz der Eingangssignale am Phasendetektor (PD) konstant bleibt.

11. Verfahren zur Phasenmessung nach einem der Ansprüche 6 bis 10, **dadurch gekennzeichnet**, daß Amplitude, Frequenz und Phase der auf einer Probenoberfläche angeregten Oberflächenwelle über die elektrischen Ansteuerungssignale einer die Oberflächenwellen erzeugenden Vorrichtung (IDW) eingestellt wird.

12. Vorrichtung zur Phasenmessung von Signalen an einem Meßpunkt mit einem Korpuskularstrahlerzeuger (EQ) zum Abtasten einer Probenoberfläche auf einer Probe (OWB), mit einer Signalkette zur Umwandlung eines von einem Meßpunkt der Probe abgeleiteten sekundären Signals (SE), wobei die Signalkette insbesondere eine Auswerteschaltung (AS) aufweist, die Auswerteschaltung (AS) einen Phasendetektor (PD) enthält, und dem Phasendetektor ein Referenzsignal mit einer Referenzfrequenz und ein sekundäres Signal, insbesondere über Teile der Auswerteschaltung (AS), zugeführt wird, **dadurch gekennzeichnet**, daß ein Regler (R) mit einem ersten Eingang am Ausgang des Phasendetektors (PD) angeschlossen ist, auf einen zweiten Eingang des Reglers (R) ein Sollwert (SW) aufgeschaltet ist, und daß der Ausgang des Reglers (R) ein Steuersignal (MS) liefert.

13. Vorrichtung zur Phasenmessung nach Anspruch 12, **dadurch gekennzeichnet**, daß die Probe (OWB) mit einem Signalgenerator (SG) verbunden ist, zur Ansteuerung der Probe (OWB) mit Ansteuersignalen.

14. Vorrichtung zur Phasenmessung nach Anspruch 12. **dadurch gekennzeichnet,** daß die Signale Oberflächenwellen sind, daß eine Vorrichtung (IDW) zur Erzeugung von Oberflächenwellen über einen Leistungsverstärker (LV) an einen Signalgenerator (SG) angeschlossen ist.

15. Vorrichtung zur Phasenmessung nach einem der Ansprüche 12 bis 14, **dadurch g e k e n n n zeichnet,** daß die Signalkette einen Detektor (DT) enthält, zur Detektion des sekundären elektrischen Signals (SE).

16. Vorrichtung zur Phasenmessung nach einem der Ansprüche 12 bis 15, **dadurch gekennzeichnet,** daß der Regler (R) einen Vergleicher (V) zum Vergleich des Ausgangssignals ($U_A$) des Phasendetektors (PD) mit dem Sollwert (SW) und einen nachgeschalteten Regelverstärker (RV) enthält.

17. Vorrichtung zur Phasenmessung nach einem der Ansprüche 12 bis 16, **dadurch gekennzeichnet,** daß der Phasendetektor (PD) ein Lock-In-Verstärker ist.

18. Vorrichtung zur Phasenmessung nach einem der Ansprüche 12 bis 16, **dadurch gekennzeichnet,** daß die Auswerteschaltung (AS) ein durchstimmbares Filter (BP) vor dem Phasendetektor (PD) zum Ausfiltern des sekundären elektrischen Signal (SE) enthält, daß das durchstimmbare Filter (BP) zur Steuerung der Mittenfrequenz mit dem Signalgenerator (SG) verbunden ist.

19. Vorrichtung zur Phasenmessung nach einem der Ansprüche 12 bis 16, **dadurch gekennzeichnet,** daß die Auswerteschaltung (AS) einen Frequenzumsetzer (FC) vor dem Phasendetektor (PD) zur Konversion der Signalfrequenz ($f_s$) des sekundären Signals (SE) auf einer festen Zwischenfrequenz ($f_{if}$) enthält.

20. Vorrichtung zur Phasenmessung nach Anspruch 19. **dadurch gekennzeichnet,** daß der Frequenzumsetzer (FC) ein durchstimmbares Filter mit nachgeschaltetem Mischer und spannungsgesteuertem Frequenzoszillator enthält, daß das durchstimmbare Filter und der Mischer mit dem Signalgenerator (SG) verschaltet sind.

21. Vorrichtung zur Phasenmessung nach einem der Ansprüche 14 bis 19, **dadurch gekennzeichnet,** daß zwischen Signalgenerator (SG) und Mischer ein Frequenzvielfacher oder Frequenzteiler (FP) geschaltet ist.

22. Vorrichtung zur Phasenmessung nach einem der Ansprüche 13 bis 21, **dadurch gekennzeichnet,** daß ein Phasenschieber (PS) zwischen Signalgenerator (SG) geschaltet ist, daß ein Ausgang des Reglers (R) mit dem Phasenschieber (PS) über eine Rückkopplung (RK) verschaltet ist.

23. Vorrichtung zur Phasenmessung nach einem der Ansprüche 13 bis 21, **dadurch gekennzeichnet,** daß ein Phasenschieber (PS) zwischen dem Signalgenerator (SG) und einem Eingang des Phasendetektors (PD) geschaltet ist. daß ein Ausgang des Reglers (R) mit dem Phasenschieber (PS) über eine Rückkopplung (RK) verschaltet ist.

24. Vorrichtung zur Phasenmessung nach einem der Ansprüche 12 bis 23, **dadurch gekennzeichnet,** daß die Auswerteschaltung (AS) einen Photomultiplier (PM) mit nachgeschaltetem Vorverstärker (VV) enthält, die am Eingang der Auswerteschaltung (AS) angeordnet sind.

25. Vorrichtung zur Phasenmessung nach einem der Ansprüche 14 bis 24, **dadurch gekennzeichnet,** daß die Oberflächenwellen mit Hilfe eines Interdigitalwandlers (IDW) erzeugt werden.

26. Vorrichtung zur Phasenmessung nach einem der Ansprüche 14 bis 24, **dadurch gekennzeichnet,** daß die Oberflächenwellen mit Hilfe eines Lasers angeregt werden.

27. Vorrichtung zur Phasenmessung nach einem der Ansprüche 14 bis 24, **dadurch gekennzeichnet,** daß die Oberflächenwellen mit Hilfe eines Elektronenstrahls angeregt werden.

# FIG 1

# FIG 2

# FIG 3

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| D,Y | ELECTRONICS, 19. Mai 1983, Seiten 132-136, New York, US; H.-P. FEUERBAUM et al.: "Scanned electron-beam probe shows surface acoustic waves in action" * Seite 132, rechte Spalte, Absatz 2 - Seite 133, linke Spalte, Absatz 1; Figur 1 * | 1,2,6,7,11-16, 19,21, 23,25 | G 01 R 25/04 |
| D,A | Idem --- | 17 | |
| Y | DE-A-1 813 188 (AGA) * Seite 1, letzter Absatz - Seite 2, Absatz 1; Seite 5, letzter Absatz - Seite 7, Absatz 1; Seite 7, letzter Absatz; Figur 3 * | 1,2,6,7,11-16, 19,21, 23,25 | |
| A | --- | 5 | |
| A | DE-A-2 354 146 (SIEMENS) * Seite 3, Absatz 4 - Seite 4, Absatz 1; Figuren 1,2 * --- | 1,9,10, 12,18, 23 | |
| D,A | JAPANESE JOURNAL OF APPLIED PHYSICS, Band 23, 1984, Supplement 23-1, Seiten 191-193, Tokyo, JP; K. YAMANOUCHI et al.: "Excitation of surface acoustic waves using electron acoustic microscope" * Seite 191, Absatz 1; Figur 1 * --- | 26,27 | RECHERCHIERTE SACHGEBIETE (Int. Cl.4) G 01 R H 03 D |
| D,A | SCANNING ELECTRON MICROSCOPY, Januar 1983, Seiten 55-63; H.P. FEUERBAUM et al.: "Examination of surface acoustic wave components using a scanning electron microscope" * Seite 57, Absatz 2 - Seite 59, rechte Spalte, Absatz 1; Figuren 9,12 * ----- | 1,2,6,7,11-15, 24,25, 27 | |

Der vorliegende Recherchenbericht wurde für alle Patentansprüche erstellt

| Recherchenort | Abschlußdatum der Recherche | Prüfer |
|---|---|---|
| DEN HAAG | 08-12-1988 | WIEMANN L. |